# EUROPÄISCHE PATENTSCHRIFT

(11) **EP 3 346 548 B1**
(45) Veröffentlichungstag und Bekanntmachung des Hinweises auf die Patenterteilung: **29.04.2020**
(21) Anmeldenummer: 18150254.3
(22) Anmeldetag: 04.01.2018
(51) Int. Cl.: H01Q 1/22, H01Q 15/00, H01Q 15/02

(54) **MODULANORDNUNG MIT EINGEBETTETEN KOMPONENTEN UND EINER INTEGRIERTEN ANTENNE, VORRICHTUNG MIT MODULANORDNUNGEN UND VERFAHREN ZUR HERSTELLUNG**
MODULE ASSEMBLY WITH EMBEDDED COMPONENTS AND AN INTEGRATED ANTENNA, DEVICE WITH MODULE ASSEMBLIES AND METHOD FOR PREPARATION
ENSEMBLE MODULAIRE POURVU DE COMPOSANTS INCORPORÉS ET D'UNE ANTENNE INTÉGRÉE, DISPOSITIF COMPRENANT DES SYSTÈMES MODULAIRES ET PROCÉDÉ DE FABRICATION

(30) Priorität: 05.01.2017 DE 102017200127
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: Ndip, Ivan, 13469 Berlin (DE); Ostmann, Andreas, 10585 Berlin (DE)
(74) Vertreter: Hersina, Günter

(56) Entgegenhaltungen:
- DE-A1-102006 023 123
- US-A1- 2009 168 367
- US-A1- 2015 325 925
- US-B1- 7 522 105

## Beschreibung

Die Erfindung bezieht sich auf eine Modulanordnung mit eingebetteten Komponenten und einer integrierten Antenne, eine Vorrichtung mit Modulanordnungen sowie auf ein Verfahren zur Herstellung einer Modulanordnung.

Modulanordnungen, auf denen elektronische Komponenten aufgebracht sind, sind in vielen Bereichen der Technik bekannt und in Anwendung. Relevante und kritische Themenbereiche bei solchen Modulanordnungen sind beispielsweise die elektrische Verbindung zwischen den Komponenten, die Kontaktierung der Komponenten von außen oder die Reduktion des Platzbedarfs der Komponenten und damit auch eine Verkleinerung der Anordnung an sich. Ziel ist es oft, die Integrationsdichte zu erhöhen.

Leiterplatten (andere Bezeichnungen sind Platine, Leiterkarte oder gedruckte Schaltung, englisch printed circuit board, PCB) als mögliche Bestandteile der Modulanordnungen bestehen im Allgemeinen aus elektrisch isolierendem Material und weisen auf ihren (Ober- bzw. Unter-)Seiten elektrisch leitende Verbindungen in Form von Leiterbahnen auf.

Es sind dabei Anordnungen mit einer Leiterplatte oder mit mehreren übereinander angeordneten Leiterplatten (sog. Multilayer-Leiterplatten) bekannt. Für die Herstellung der Leiterplatten sind teilweise sog. PrePregs in Verwendung. Dabei handelt es sich um mit Harzen vorimprägnierte textile Faser-Matrix-Halbzeuge, die unter Druck und Temperatur aushärten.

Im Stand der Technik ist es bekannt, Komponenten oder beispielsweise Chips in die Leiterplatten einzufügen (englisch embedding). Unterschieden werden beispielsweise zwei grundlegende Verfahren, die sich darin voneinander unterscheiden, ob die Kontakte bzw. Pins der Komponenten entweder der Leiterplatte (sog. Face-Down-Embedding) oder von der Leiterplatte weggewandet sind (sog. Face-Up-Embedding). Dabei sind die Komponenten insbesondere im Material der Leiterplatte eingebunden (siehe z. B. DE 199 54 941 A1, DE 10 2005 032 489 B3 oder DE 694 30 765 T2).

Die Druckschrift US 2009/168367 A1 bezieht sich auf eine elektronische Vorrichtung mit einer Antenne und einem elektronischen Element, das Wärme erzeugt, wobei die Wärme zuverlässig abgestrahlt werden soll, ohne die Montierbarkeit ("mountability") zu verschlechtern.

Die Druckschrift DE 10 2006 023123 A1 bezieht sich auf ein Halbleitermodul mit Komponenten für die Höchstfrequenztechnik, z.B. für Radargeräte, wobei die Signale im Frequenzbereich zwischen 1 GHz und 100 GHz übertragen, verarbeitet, gesendet und/oder empfangen werden.

Die Druckschrift US2015/0325925 A1 bezieht sich auf ein Modul eines phasengesteuerten Gruppenstrahlers, in dessen Substrat eine integrierte Hochfrequenzschaltung eingebettet ist.

Die Aufgabe der Erfindung besteht darin, eine Modulanordnung mit eingebetteten Komponenten und einer integrierten Antenne, eine Vorrichtung mit Modulanordnungen sowie ein Verfahren zur Herstellung einer solchen Modulanordnung vorzuschlagen.

Die Erfindung löst die Aufgabe durch eine Modulanordnung.

Dabei weist die Modulanordnung mindestens eine Antennenschicht, eine Abschirmschicht, eine Verteilungsschicht und eine Komponentenschicht auf. Die Antennenschicht trägt eine integrierte Antennenvorrichtung. Die Abschirmschicht ist derartig ausgestaltet, eine abschirmende Wirkung gegenüber elektromagnetischen Signalen zu haben. Die Verteilungsschicht weist Strukturen zum Verteilen von Signalen und/oder elektrischer Energie auf. Die Komponentenschicht trägt eingebettete elektronische Komponenten.

Die Antennenvorrichtung ist dabei in der Antennenschicht integriert und die elektronischen Komponenten sind in der Komponentenschicht eingebettet.

Die Modulanordnung weist dabei in Ausgestaltungen noch andere Schichten, die hier nicht weiter beschrieben werden, auf. So tragen beispielsweise in einer Ausgestaltung auch weitere Schichten elektronische Komponenten. Alternativ oder ergänzend bestehen je nach Ausgestaltung die oben genannten Schichten (als Antennen-, Abschirm-, Verteilungs- und/oder Komponentenschicht) aus mehreren Einzelschichten.

In einer Ausgestaltung handelt es sich bei wenigstens einer der vorgenannten Schichten um eine Leiterplattenschicht.

In einer Ausgestaltung befindet sich die Antennenschicht auf der Oberseite der Modulanordnung. Dabei befindet sich in einer weiteren Ausgestaltung die Antennenvorrichtung zumindest mit dem für die Abstrahlung der elektromagnetischen Signale aktiven Abschnitt auf der Oberseite der Antennenschicht.

In einer Ausgestaltung ist - vorzugsweise oberhalb der Antennenschicht - mindestens eine Struktur zur Fokussierung der Strahlung der Antennenvorrichtung vorhanden. In einer weiteren Ausgestaltung befindet sich oberhalb der Antennenschicht mindestens eine Struktur zur Fokussierung der Strahlung der Antennenvorrichtung. Die Struktur ist in einem Ausführungsbeispiel eine Linse.

In einer Ausgestaltung sind zumindest die Antennenschicht und die Komponentenschicht jeweils Leiterplatten.

Eine Ausgestaltung der Modulanordnung besteht darin, dass ausgehend von einer Oberseite zu einer Unterseite der Modulanordnung folgende Abfolge gegeben ist: die Antennenschicht, die Abschirmschicht, die Verteilungsschicht und die Komponentenschicht. Die Abschirmschicht schützt somit insbesondere die elektronischen Komponenten der Komponentenschicht gegenüber den elektromagnetischen Signalen der Antennenvorrichtung bzw. insbesondere gegenüber Streufeldern. Umgekehrt schützt die Abschirmschicht die Antennenvorrichtung auch vor Einwirkungen der Komponenten, z. B. der Chips der Komponentenschicht. Die Abschirmschicht weist in einer Ausgestaltung eine Metallschicht auf.

Die der Abschirmschicht folgende Verteilungsschicht weist die Strukturen, z. B. Leitungen, Kontakte, Durchkontaktierungen usw. auf, damit die Antennenvorrichtung mit den Komponenten der Komponentenschicht verbunden ist. Weiterhin wird über die Verteilungsschicht auch die Kontaktierung der Komponenten untereinander realisiert. Die Verteilungsschicht erlaubt somit die Kontaktierung der Bestandteile der Modulanordnung untereinander und vor allem innerhalb der Modulanordnung selbst. Letztes bedeutet, dass in einer Ausgestaltung keine Kontaktierung nach außen geführt ist. Die elektronischen Komponenten sind in einer Ausgestaltung Chips, integrierte Schaltungen oder passive Bauteile, z. B. Induktivitäten, Kondensatoren, elektrische Widerstände, Filter, Schalter oder Richtkoppler.

In einer Ausgestaltung sind auf der Oberseite der Modulanordnung und damit auch auf der Oberseite der Antennenschicht Metallisierungen aufgebracht.

Die Modulanordnung kann dabei insbesondere als elektronisches Modul bezeichnet werden.

In einer Ausgestaltung weist die Antennenvorrichtung ein Element auf oder besteht in einer weiteren Ausgestaltung aus mehreren Elementen, die zu einem Array zusammengefasst sind.

Die Antennenvorrichtung wird in einer Ausgestaltung beaufschlagt durch eine vertikale Zuleitung, durch sog. "Proximity feed", durch sog. "Aperture coupled feed" oder durch planare Zuleitungen. Je nach Art der Ansteuerung sieht es eine Ausgestaltung vor, dass wenigstens eine Metallschicht unterhalb der Antennenschicht für die Ansteuerung vorhanden ist.

Die Antennenvorrichtung weist je nach Ausgestaltung beispielweise mindestens eine Patchantenne, eine Grid Array-Antenne oder eine Schlitzantenne auf. Alternativ weist sie mindestens eine Antenne mit einem Wellenleiter auf, der zumindest teilweise durch die Antennenschicht gebildet wird. In anderen Ausgestaltungen sind Dipol-, Monopol-, Yagi-Uda- oder Vivaldi-Antennen beispielsweise vorgesehen. In alternativen oder ergänzenden Ausgestaltungen sind rekonfigurierbare und/oder kleine Antennen (sog. "electrically small antenna", die sehr klein gegenüber ihrer Radiansphere gemäß der Definition von H. A. Wheeler sind) vorgesehen. Andere Antennenkonfigurationen sind in alternativen oder ergänzenden Ausgestaltungen vorgesehen.

In dem Fall, dass es sich bei der Antennenvorrichtung um eine rekonfigurierbare Antenne handelt, sind in einer Ausgestaltung die hierfür erforderlichen Komponenten, z. B. Schalter oder Dioden, Teil der Antennenschicht und sind in einer alternativen Ausgestaltung in einer Schicht unterhalb der Antennenschicht - z. B. in der Komponentenschicht - angeordnet.

In einer Ausgestaltung ist die Antennenschicht frei von elektronischen Komponenten, so dass die gesamte obere Hälfte mit einem oder mehreren Antennenstrahlen bedeckt ist.

Wenigstens eine der Schichten der Modulanordnung besteht beispielsweise aus einem Polymer, aus einem für Hochfrequenz geeigneten Laminat, aus einem Glas oder einem Dielektrikum.

In einer Ausgestaltung ist mindestens ein Metallkern (alternative Bezeichnung ist: Metallschicht) vorhanden, wobei der Metallkern unterhalb der Komponentenschicht befindlich ist. Die Bezeichnung "unterhalb" bezieht sich insbesondere auf die beschriebene Abfolge der Schichten, sodass also die Antennenschicht oberhalb der Komponentenschicht befindlich ist.

Eine Ausgestaltung der Modulanordnung umfasst, dass Kontakte zur elektrischen Kontaktierung der Modulanordnung auf der Unterseite befindlich sind. In einer Ausgestaltung befinden sich die Kontakte (z. B. Ball Grid Arrays) für die elektrische Kontaktierung nur auf der Unterseite der Modulanordnung. Damit befindet sich auf der Oberseite die Antennenvorrichtung und auf der Unterseite wird die Kontaktierung bzw. der Anschluss der Modulanordnung mit anderen Komponenten, Bauteilen, Vorrichtungen usw. realisiert.

Eine Ausgestaltung der Modulanordnung besteht darin, dass nur die Komponentenschicht elektronische Komponenten trägt. In dieser Ausgestaltung sind alle elektronischen Komponenten in der Komponentenschicht zusammengefasst und gebündelt. Dies vereinfacht insbesondere die Fertigung der Modulanordnung.

Bei der Modulanordnung sind die elektronischen Komponenten in der Komponentenschicht eingebettet (bzw. integriert). Kontakte wenigstens einiger Komponenten zeigen dabei in einer Ausgestaltung in Richtung der Oberseite der Modulanordnung und werden teilweise durch entsprechende Verbindungselemente oder Verbindungsstrukturen auf die Unterseite für die Kontaktierung nach außen geführt.

In einer Ausgestaltung wird wenigstens eine elektronische Komponente direkt in der Komponentenschicht erzeugt. Dies im Gegensatz zu separaten elektronischen Komponenten, die mit der Komponentenschicht verbunden bzw. in diese eingebracht werden. Die so in der Komponentenschicht erzeugten elektronischen Komponenten sind beispielweise als Kondensatoren ausgestaltet, die sich vorzugsweise in der Nähe der aktiven Komponenten, z. B. der Chips befinden. So lässt sich die Energieverteilung stabilisieren. Alternativ oder ergänzend sind Induktivitäten als elektronische Komponenten vorgesehen.

Die Verteilungsschicht ist insbesondere dafür ausgestaltet, elektrische Energie und/oder Signale zwischen Komponenten und/oder zwischen Komponenten und der Antennenvorrichtung zu übertragen. Weitere Übertragungsstrukturen befinden sich dabei - je nach Ausgestaltung - auch in den anderen Schichten, um die jeweils betroffenen Komponenten bzw. die Antennenvorrichtung zu erreichen. Dabei handelt es sich beispielsweise um Durchkontaktierungen. In einer Ausgestaltung ist der Abstand zwischen der Antennenvorrichtung und weiteren Komponenten, z. B. Chips, bzw. zwischen Komponenten untereinander möglichst kurz gehalten. Dies dient dazu, dass Signale möglichst kaum beeinflusst werden.

Eine Ausgestaltung der Modulanordnung besteht darin, dass die Modulanordnung eine Temperierungsschicht aufweist. Die Temperierungsschicht dient dem Abführen bzw. dem Verteilen von Wärme, die z. B. von den elektronischen Komponenten erzeugt wird. In einer Ausgestaltung besteht die Temperierungsschicht aus einem thermisch gut leitfähigen Material. Das Material der Temperierungsschicht ist in einer Ausgestaltung insbesondere ein Dielektrikum.

Eine Ausgestaltung der Modulanordnung umfasst, dass die Temperierungsschicht ausgehend von einer Oberseite zu einer Unterseite der Modulanordnung der Komponentenschicht folgt. Die Temperierungsschicht befindet sich in dieser Ausgestaltung unterhalb der Komponentenschicht und ist damit in einer Ausgestaltung auch die unterste Schicht der Modulanordnung. Daher sind in einer Ausgestaltung die oben angesprochenen Kontakte zur Kontaktierung der Modulanordnung von außen durch die Temperierungsschicht zu der Unterseite der Modulanordnung hindurchgeführt.

In einer Ausgestaltung ist mindestens eine Kühlkomponente vorhanden. Dies dient insbesondere dazu, Wärme der elektronischen Komponenten abzuführen. In einer Ausgestaltung handelt es sich beispielweise um einen "Heat sink".

In einer Ausgestaltung ist vorgesehen, dass mindestens eine eingebettete elektronische Komponente mit einem Kühlkörper - vorzugsweise unmittelbar oder in einer Ausgestaltung über einen thermisch leitfähigen Kleber - thermisch verbunden ist, und/oder dass mindestens eine eingebettete elektronische Komponente über einen Metallkern mit einem Kühlkörper thermisch verbunden ist, und/oder dass mindestens eine eingebettete elektronische Komponente über mindestens eine Durchkontaktierung (eine andere Bezeichnung ist: Thermal-Via) mit einem Kühlkörper thermisch verbunden ist, und/oder dass mindestens eine eingebettete elektronische Komponente über einen Metallkern und über mindestens eine Durchkontaktierung mit einem Kühlkörper thermisch verbunden ist. Der Kühlkörper ist z. B. ein "Heat sink".

Eine Ausgestaltung der Modulanordnung besteht darin, dass mindestens eine elektronische Komponente mit mindestens einer Kühlkomponente verbunden ist. In einer Ausgestaltung sind wärmeleitende Elemente in der Modulanordnung vorhanden, die mit den Komponenten thermisch gekoppelt sind und Wärme abführen und/oder zu den Kühlkomponenten hinführen.

Die erfindungsgemäße Modulanordnung umfasst, dass die Antennenschicht Löcher aufweist. Die Löcher bilden in einer Ausgestaltung eine photonische Bandlückenstruktur (englisch photonic bandgap structure), die Oberflächenwellen filtert. Alternativ oder ergänzend reduzieren die Löcher die Permittivität der Antennenschicht. Die Ausgestaltungen erlauben es, größer dimensionierte Antennenstrukturen im Millimeterwellen- oder Terahertz-Bereich zu verwenden. Die größeren Abmessungen reduzieren dabei auch die Auswirkungen von Fertigungstoleranzen.

Alternativ oder ergänzend sind elektromagnetische Bandlückenstrukturen in der Modulanordnung vorhanden.

Eine Ausgestaltung der Modulanordnung besteht darin, dass die Antennenvorrichtung eine geschlossene Oberfläche aufweist.

Eine Ausgestaltung der Modulanordnung umfasst, dass die Antennenvorrichtung eine unterbrochene Oberfläche aufweist.

Eine Ausgestaltung der Modulanordnung besteht darin, dass die Antennenvorrichtung derartig ausgestaltet ist, elektromagnetische Signale in eine Richtung senkrecht auf der Oberseite der Modulanordnung fort von der Oberseite auszusenden. Die Antennenvorrichtung strahlt in dieser Ausgestaltung elektromagnetische Signale in einer vertikalen Ebene aus, die senkrecht auf der Ebene der Antennenvorrichtung steht.

Eine Ausgestaltung der Modulanordnung umfasst, dass die Antennenvorrichtung derartig ausgestaltet ist, elektromagnetische Signale in eine Richtung auszusenden, die in einer Ebene der Oberseite der Modulanordnung liegt. In dieser Ausgestaltung strahlt die Antennenvorrichtung elektromagnetische Signale in azimutaler Richtung aus, also insbesondere bezogen auf die Modulanordnung seitlich aus.

In einer weiteren Ausgestaltung strahlt die Antennenvorrichtung die Signale in vertikaler und azimutaler Richtung aus.

Die Antennenvorrichtung ist in einer Ausgestaltung zum Senden und zum Empfangen von elektromagnetischen Signalen ausgestaltet.

Eine Ausgestaltung der Modulanordnung besteht darin, dass die Abschirmschicht mindestens zwei Teilschichten aufweist. Dabei befindet sich in einer Ausgestaltung zwischen den zwei Teilschichten eine Aussparung. In einer Ausgestaltung befinden sich Abstandshalter zwischen den zwei Teilschichten. Die Teilschichten werden somit in einer Ausgestaltung durch eine Luftschicht voneinander getrennt. Kontaktierungen der Antennenvorrichtung werden dabei über die Aussparung hinweggeführt. In einer alternativen Ausgestaltung befinden sich Bonding-Elemente zwischen den Teilschichten, so dass eine möglichst feste Verbindung zwischen den Teilschichten erzeugt wird.

Eine Ausgestaltung der Modulanordnung umfasst, dass die Temperierungsschicht thermische Durchkontaktierungen aufweist. Die Durchkontaktierungen (sog. "Thermal Vias") dienen dabei der Abführung der Wärme.

In einer Ausgestaltung der Modulanordnung ist vorgesehen, dass in der Modulanordnung mindestens eine elektronische Komponente eingebettet ist, dass in der Modulanordnung mindestens eine Antennenvorrichtung integriert ist, und dass mindestens eine Kühlkomponente zum Abtransport von thermischer Energie vorhanden ist.

In einer Ausgestaltung der Modulanordnung ist vorgesehen, dass das Herstellungsverfahren der Antennenschicht und/oder das Material der Antennenschicht unterschiedlich zum Herstellungsverfahren anderer Schichten bzw. zu Materialien anderer Schichten sind/ist. In dieser Ausgestaltung unterscheiden sich somit die Herstellungsverfahren der Antennenschicht bzw. der anderen Schichten oder restlichen Schichten der Modulanordnung voneinander. Alternativ oder ergänzend bestehen auch Materialunterschiede.

Gemäß der Erfindung sind in der Antennenschicht Löcher angeordnet. Dabei sind die Löcher so ausgestaltet und angeordnet, dass sich eine photonische Bandlückenstruktur ergibt, um Oberflächenwellen zu filtern. Alternativ oder ergänzend wird durch die Löcher die Permittivität der Antennenschicht erniedrigt.

Weiterhin löst die Erfindung die Aufgabe durch eine Vorrichtung mit Modulanordnungen, wobei die Modulanordnungen nach einer der vorgenannten Ausgestaltungen ausgeführt sind.

Die Vorrichtung verfügt über mehrere Modulanordnungen, die jeweils eine Antennenvorrichtung aufweisen und in einer Ausgestaltung insbesondere so angesteuert werden, dass sie gemeinsam eine gewünschte Strahlungscharakteristik erzeugen.

Eine Ausgestaltung der Vorrichtung besteht darin, dass die Modulanordnungen in einer Matrix angeordnet sind. In dieser Ausgestaltung bilden die Modulanordnungen bzw. insbesondere deren Antennenvorrichtungen ein sog. Array. Dabei ist in einer Ausgestaltung eine n ^{∗} n Anordnung vorgesehen, so dass n Antennenvorrichtungen in jeder von n Reihen vorgesehen sind.

Die obigen Ausgestaltungen der Modulanordnung lassen sich entsprechend auch für die Vorrichtung übertragen, sodass hier eine Wiederholung unterlassen wird.

Weiterhin löst die Erfindung die Aufgabe durch ein Verfahren zum Erzeugen einer Modulanordnung.

Das Verfahren umfasst dabei zumindest die folgenden Schritte:
- eine Antennenschicht mit einer integrierten Antennenvorrichtung wird erzeugt,
- eine Abschirmschicht wird erzeugt,
- eine Verteilungsschicht wird erzeugt,
- eine Komponentenschicht mit eingebetteten Komponenten wird erzeugt, und
- mindestens die Antennenschicht, die Abschirmschicht, die Verteilungsschicht und die Komponentenschicht werden miteinander verbunden und/oder zumindest teilweise gemeinsam miteinander erzeugt.

In einer weiteren Ausgestaltung wird ein Metallkern (alternative Bezeichnung: Metallschicht) vorzugsweise unterhalb mindestens einer eingebetteten Komponente erzeugt.

In einer weiteren Ausgestaltung wird eine Struktur zur Fokussierung der Antennenstrahlung erzeugt.

In einer anderen Ausgestaltung wird mindestens ein Kühlkörper aufgebracht.

In einer weiteren Ausgestaltung wird mindestens eine Struktur zur Fokussierung der Strahlung der Antennenvorrichtung erzeugt. Dies Struktur ist beispielsweise eine Linse.

Die einzelnen Schichten werden in einer Ausgestaltung jeweils separat erzeugt und anschließend miteinander verbunden. In einer alternativen Ausgestaltung werden zumindest zwei Schichten gemeinsam erzeugt. In einer Ausgestaltung wird zumindest eine Schicht separat von den anderen Schichten erzeugt.

In einer Ausgestaltung wird die Antennenschicht separat von den anderen Schichten erzeugt und anschließend mit diesen verbunden.

In einer Ausgestaltung wird eine Antennenvorrichtung auf und/oder zumindest teilweise in der Antennenschicht erzeugt und anschließend wird die Antennenschicht mit den anderen Schichten verbunden.

Die Komponentenschicht wird derartig erzeugt, dass elektronische Komponenten in die Komponentenschicht integriert bzw. eingebettet werden.

In einer Ausgestaltung wird mindestens ein Kühlkörper aufgebracht und in einer weiteren Ausgestaltung thermisch leitend mit mindestens einer elektronischen Komponente verbunden.

Die obigen Ausgestaltungen der Modulanordnung lassen sich durch Schritte von entsprechenden Ausgestaltungen des Verfahrens realisieren, so dass hier auf eine Wiederholung der Ausführungen verzichtet sei.

Im Einzelnen gibt es eine Vielzahl von Möglichkeiten, die erfindungsgemäße Modulanordnung, die Vorrichtung mit Modulanordnungen sowie das Verfahren auszugestalten und weiterzubilden. Dazu wird verwiesen einerseits auf die Patentansprüche, andererseits auf die folgende Beschreibung von Ausführungsbeispielen in Verbindung mit der Zeichnung. Es zeigen:
- Fig. 1: einen Schnitt durch eine schematische Darstellung einer ersten Ausgestaltung der Modulanordnung,
- Fig. 2: einen Schnitt durch eine schematische Darstellung einer zweiten Ausgestaltung der Modulanordnung,
- Fig. 3: einen Schnitt durch eine schematische Darstellung einer dritten Ausgestaltung der Modulanordnung,
- Fig. 4: einen Schnitt durch eine schematische Darstellung einer vierten Ausgestaltung der Modulanordnung,
- Fig. 5: einen Schnitt durch eine schematische Darstellung einer fünften Ausgestaltung der Modulanordnung,
- Fig. 6: einen Schnitt durch eine schematische Darstellung einer sechsten Ausgestaltung der Modulanordnung,
- Fig. 7: einen Schnitt durch eine schematische Darstellung einer siebten Ausgestaltung der Modulanordnung,
- Fig. 8: einen Schnitt durch eine schematische Darstellung einer achten Ausgestaltung der Modulanordnung,
- Fig. 9: einen Schnitt durch eine schematische Darstellung einer neunten Ausgestaltung der Modulanordnung,
- Fig. 10: einen Schnitt durch eine schematische Darstellung einer zehnten Ausgestaltung der Modulanordnung,
- Fig. 11: einen Schnitt durch eine schematische Darstellung einer elften Ausgestaltung der Modulanordnung,
- Fig. 12: einen Schnitt durch eine schematische Darstellung einer zwölften Ausgestaltung der Modulanordnung,
- Fig. 13: eine Draufsicht auf eine schematische Darstellung einer ersten Ausgestaltung der Vorrichtung mit Modulanordnungen, und
- Fig. 14: eine Draufsicht auf eine schematische Darstellung einer zweiten Ausgestaltung der Vorrichtung mit Modulanordnungen.

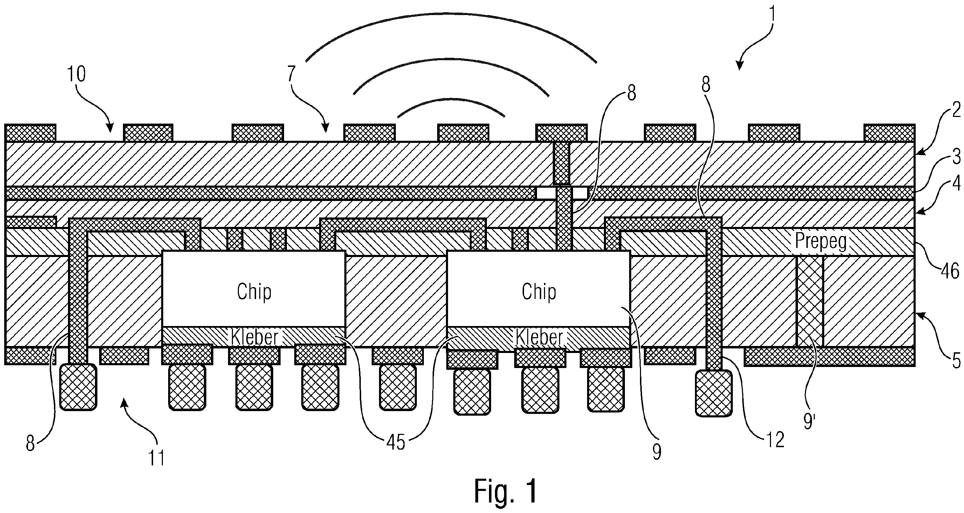

Die Modulanordnung 1 der Fig. 1 verfügt über eine Oberseite 10 und eine Unterseite 11. Die Oberseite 10 dient hier der Aussendung von elektromagnetischen Signalen. Die Unterseite 11 erlaubt die elektrische Kontaktierung der Modulanordnung 1.

Ausgehend von der Oberseite 10 zur Unterseite 11 sind die folgenden Schichten vorhanden: Antennenschicht 2, Abschirmschicht 3, Verteilungsschicht 4 und Komponentenschicht 5.

Die Antennenschicht 2 - die in dem Beispiel eine Leiterplatte ist - verfügt über eine Antennenvorrichtung 7, die hier auf der Oberseite 10 befindlich ist und die der Ausstrahlung der Signale dient. Die Abschirmschicht 3 verfügt hier als Beispiel über eine metallische Lage, die eine Abschirmung von Streufeldern der Antennenvorrichtung 7 bewirkt.

In der Verteilungsschicht 4 sind entsprechende Strukturen 8 vorhanden, um Signale oder elektrische Energie zur Antennenvorrichtung 7 bzw. zwischen Komponenten 9, 9' der Komponentenschicht 5 zu verteilen. Weitere Verbindungsstrukturen 8 erstrecken sich noch durch die Antennenschicht 2 und die Abschirmschicht 3 sowie durch die Komponentenschicht 5.

In der Komponentenschicht 5 schließlich befinden sich elektronische Komponenten 9, 9', die beispielweise der Ansteuerung der Antennenvorrichtung 7 dienen. Die elektronischen Komponenten 9, 9' sind dabei in der Komponentenschicht 5, die eine Leiterplatte ist, eingebettet (bzw. integriert). Gezeigt sind hier zwei Chips 9 sowie ein passives Bauteil 9' (z. B. ein Kondensator, eine Spule, ein Widerstand, eine Diode usw.). Die Komponentenschicht 5 und die Verteilungsschicht 4 sind hier durch eine Prepreg-Schicht 46 miteinander fixiert.

Die Kontakte der Chips 9 sind hier der Verteilungsschicht 4 zugewandt und werden durch die Verbindungsstrukturen 8 zu den Kontakten 12 geführt. Weitere Kontakte der Chips 9 sind innerhalb der Verteilungsschicht 4 mit den jeweils anderen elektronischen Komponenten 9, 9' - also anderen Chips bzw. passiven Bauteilen - verbunden.

Die Chips 9, bei denen für die Befestigung auch ein Kleber 45 auf der der Unterseite 11 zugewandten Seite in Anwendung kommt, sind hier mit nach außen geführten Kontakten 12 verbunden, die auf der Unterseite 11 befindlich sind und die eine Kontaktierung nach außen erlauben. Auf der Unterseite 11 sind hier auch Ball Grid Array Lotkugeln vorhanden.

Die Unterseite 11 ist hier insbesondere derartig ausgestaltet, dass über sie die Modulanordnung 1 auf einer weiteren Komponente oder auf einem System, z. B. als Modul aufgebracht und dort fixiert werden kann.

Bei den folgenden Varianten der Modulanordnung 1 wird, um Wiederholungen zu vermeiden, nur der jeweilige Unterschied zu der Variante diskutiert, die in der Fig. 1 dargestellt ist.

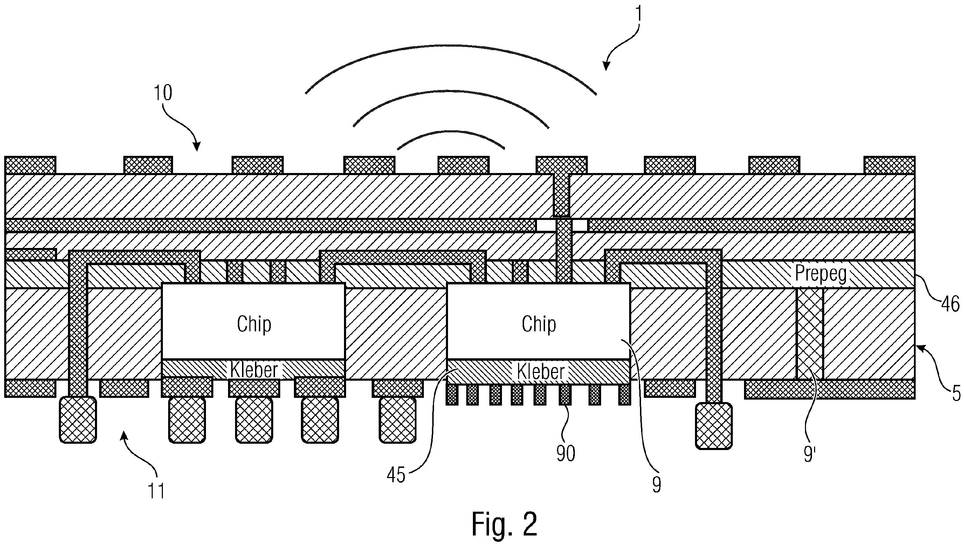

Die in der Fig. 2 gezeigte Variante der Modulanordnung 1 unterscheidet sich von der Variante der Fig. 1 darin, dass ein Chip 9 über einen Kleber 45 mit einem Kühlkörper 90 zur Abführung der Wärme des Chips kontaktiert ist. Der Kühlkörper 90 mündet dabei auf der Unterseite 11 der Modulanordnung 1, so dass die Wärme im verbauten Zustand an nachfolgende Elemente übertragen werden kann.

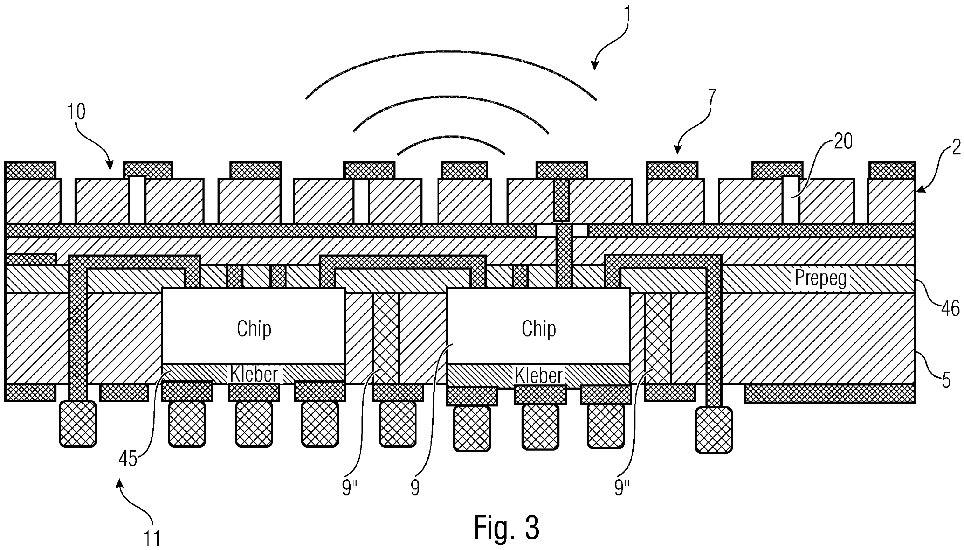

Die Variante der Fig. 3 weist in der Komponentenschicht 5 keine separaten Bauteile 9' (vgl. Fig. 1 und 2) auf, sondern verfügt hier über direkt in der Schicht 5 erzeugte elektronische Komponenten 9". Dabei handelt es sich hier beispielshaft um Kondensatoren, die in der Nähe der Chips 9 angeordnet sind und für deren stabile Energieversorgung sorgen. Weiterhin sind in der Antennenschicht 2 Löcher 20 eingebracht. Insbesondere sind die Löcher 20 so ausgestaltet und angeordnet, dass sich eine photonische Bandlückenstruktur ergibt, um Oberflächenwellen zu filtern. Weiterhin erniedrigt sich so die Permittivität der Antennenschicht 2.

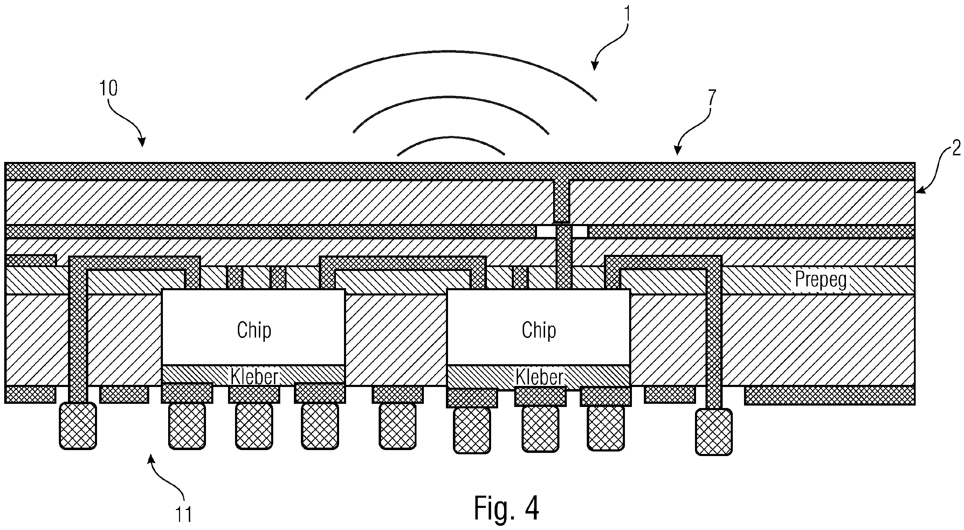

Waren bei den Varianten der Fig. 1 bis 3 die Antennenvorrichtungen 7 jeweils so ausgestaltet, dass sich eine unterbrochene Oberfläche auf der Oberseite 10 ergab, so verfügt die Antennenvorrichtung 7 in der Variante der Fig. 4 über eine teilweise durchgehend geschlossene Oberfläche (z. B. in Form einer Metallisierung). Bei der unterbrochenen Oberfläche zeigt sich somit das eigentliche Trägermaterial oder eine ggf. vorhandene Schutzschicht der Antennenschicht 2.

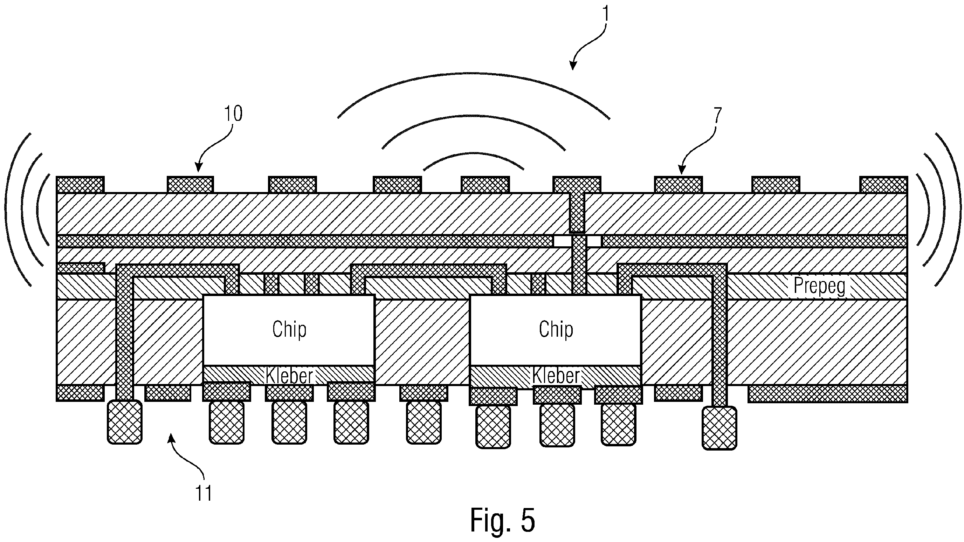

Die Fig. 5 verdeutlicht, dass die elektromagnetischen Signale nicht nur in vertikaler Richtung ausgestrahlt werden, sondern dass es manche Antennenvorrichtungen 7 auch erlauben, Signale in azimutaler Richtung auszusenden. Hier werden Signale nicht nur vertikal, sondern auch zu den beiden Seiten der Antennenvorrichtung 1 ausgestrahlt.

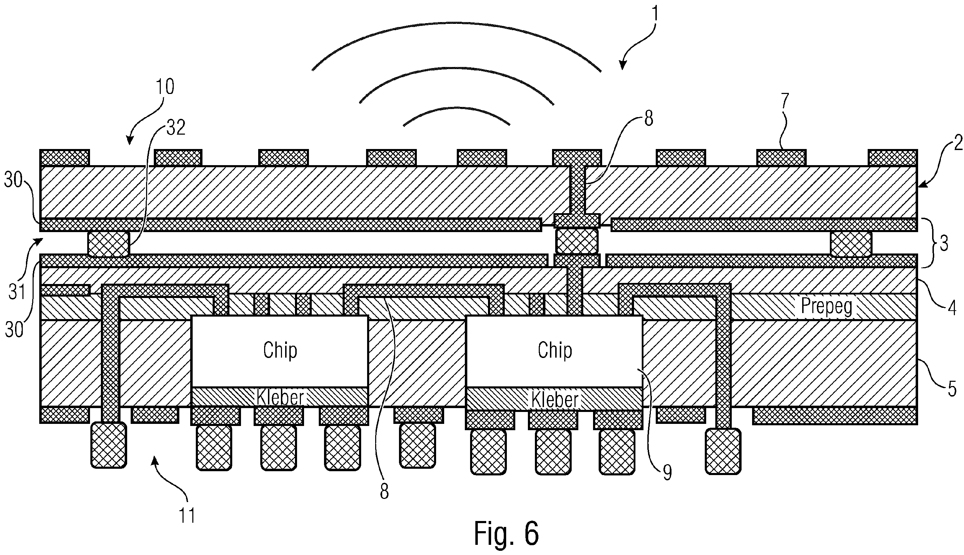

In der Variante der Fig. 6 besteht die Abschirmschicht 3 aus zwei Teilschichten 30, zwischen denen sich eine Aussparung 31 als Luftspalt befindet. Verbunden sind die beiden Teilschichten 30 durch mehrere Abstandshalter 32, durch die hier auch die Verbindungsstruktur 8 zu der Antennenvorrichtung 7 verläuft. Durch diese Ausgestaltung lässt sich die Abschirmung entsprechend optimieren. Weiterhin ist auch eine größere thermische Entkopplung gegeben.

Zudem ergibt sich der Vorteil, dass die Antennenvorrichtung 7 mit einem geeigneten Substrat hergestellt und optimiert wird, um anschließend über die Abstandshalter 32 als Teile einer Verbindungsstruktur mit der restlichen Modulanordnung verbunden zu werden. Die Antennenschicht 2 besteht in dieser Ausgestaltung der Fig. 6 beispielsweise aus einem gänzlich anderen Material als die anderen Schichten. In einer Ausgestaltung handelt es sich bei der Antennenschicht 2 nicht um ein übliches Leiterplattenmaterial. Daher unterscheidet sich auch die Herstellungsmethode der Antennenschicht 2 von den Herstellungsmethoden, die für die anderen Schichten zur Anwendung kommen.

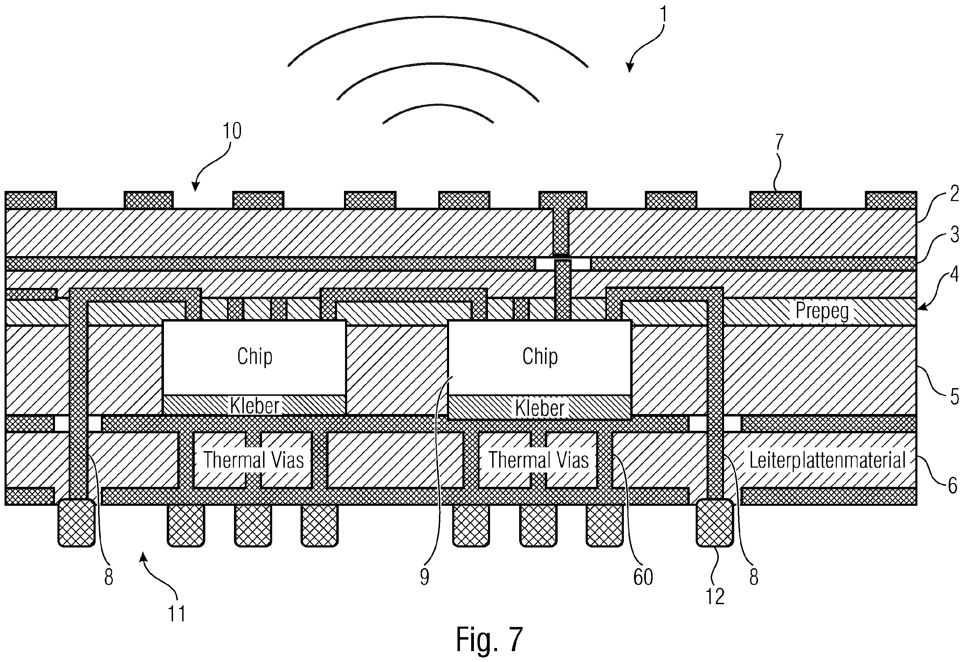

Die Fig. 7 zeigt den Fall, dass sich unterhalb der Komponentenschicht 5 noch eine Temperierungsschicht 6 befindet. Die Temperierungsschicht 6 besteht hier beispielsweise hauptsächlich aus einem thermisch leitfähigen Leiterplattenmaterial, durch das thermische Durchkontaktierungen 60 hindurchgeführt sind. Die Durchkontaktierungen 60 befinden sich hier insbesondere unterhalb der Chips 9 der Komponentenschicht 5, um deren Wärme abzuführen. Die Kontaktierungen der Chips 9 sind hier entsprechend durch die Temperierungsschicht 6 zu der Unterseite 11 der Modulanordnung 1 und hin zu den Kontakten 12 geführt.

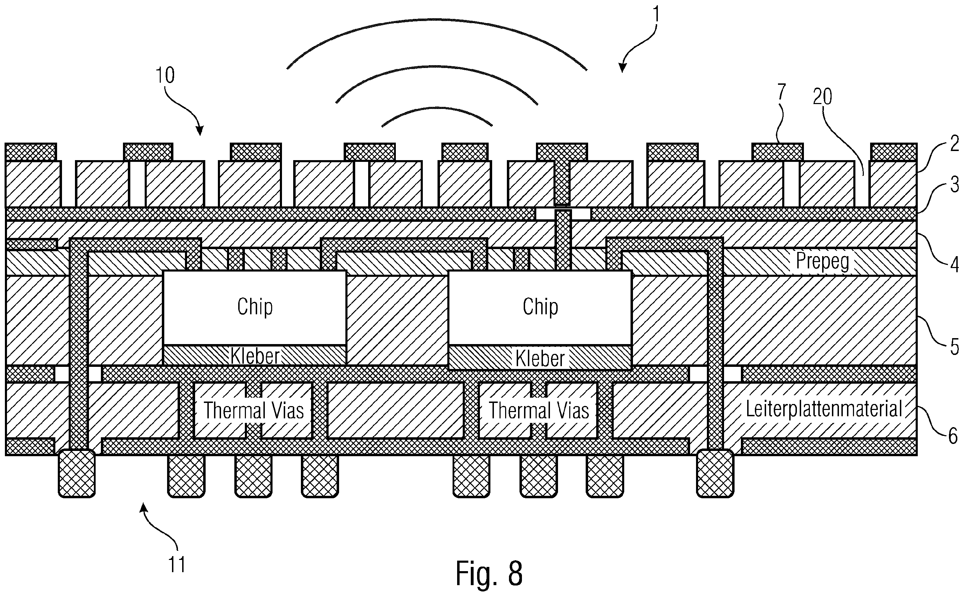

In der Fig. 8 ist eine Abwandlung der Variante der Fig. 7 gezeigt. Dabei verfügt die Antennenschicht 2 über Löcher 20, die sich hier zum Teil unterhalb der Bereiche der Oberfläche 10 der Modulanordnung 1 befinden, die frei von der Antennenvorrichtung 7 sind. Somit ergibt sich auch hier eine Temperierungs- und insbesondere Kühlmöglichkeit.

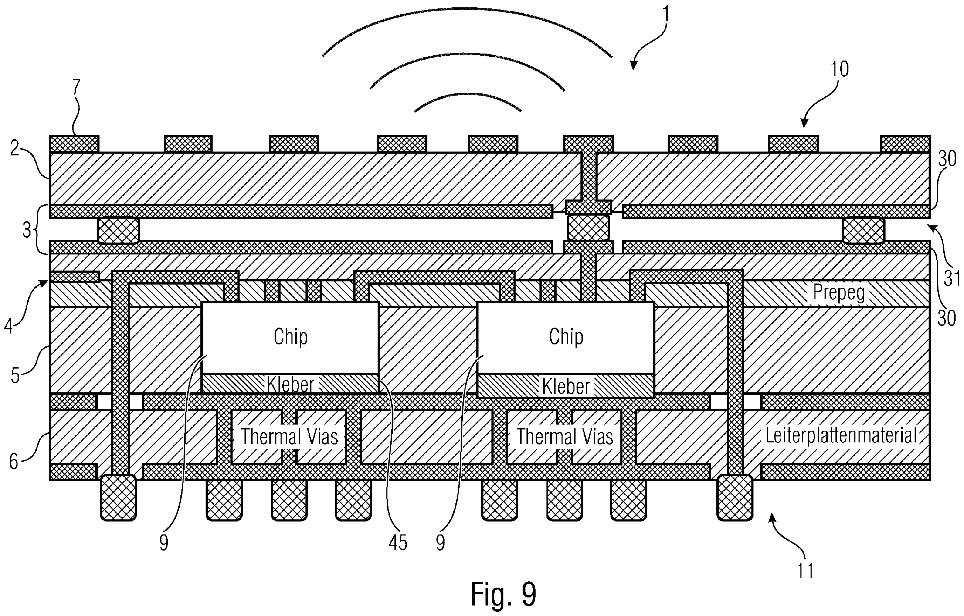

Die Variante der Fig. 9 verfügt über eine Temperierungsschicht 6 und über eine mehrteilige Abschirmschicht 3. Die Chips 9 als Beispiele für die elektronischen Komponenten sind mit einem Kleber 45 mit der Temperierungsschicht 6 verbunden. Ein Kleber 45 erlaubt auch in den anderen Ausgestaltungen beispielsweise die Verbindung der einzelnen Schichten untereinander.

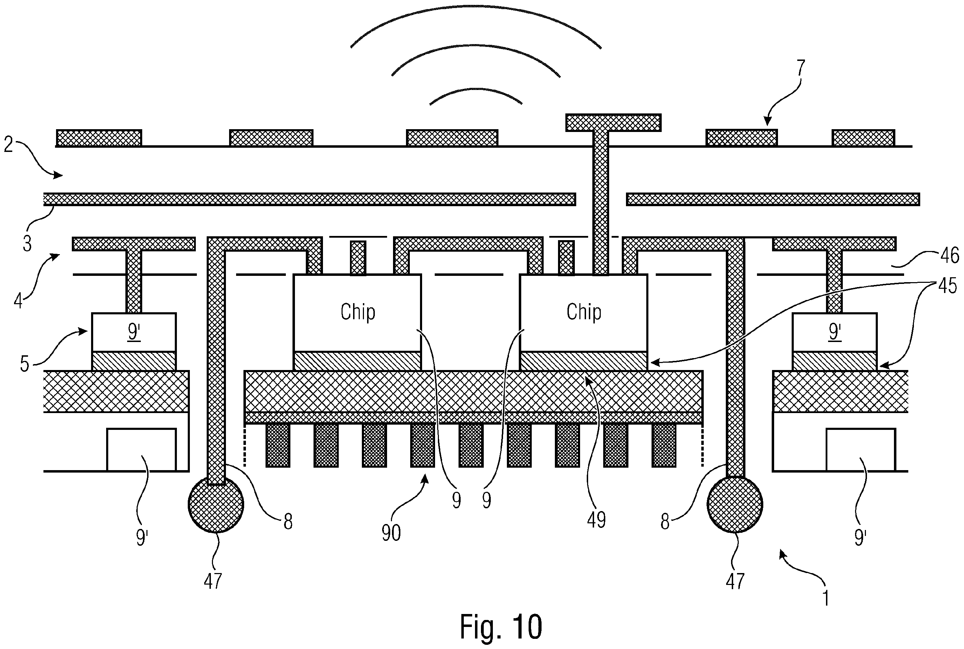

Die Variante der Modulanordnung 1 der Fig. 10 besteht aus mehreren Lagen oder Schichten.

Dazu gehört die Antennenschicht 2 mit der integrierten Antennenvorrichtung 7, die hier noch oben abstrahlt. Darunter befindet sich die Abschirmschicht 3, durch die eine elektrische Verbindung zwischen der Antennenvorrichtung 7 und einem Chip als elektronischer Komponente 9 geführt ist. Unterhalb der Abschirmschicht 3 befindet sich die Verteilungsschicht 4 und darunter die Komponentenschicht 5, die selbst wiederum mehrere Schichten oder Lagen aufweist. Die Verteilungsschicht 4 und die Komponentenschicht 5 sind über eine PrePreg-Schicht 46 miteinander verbunden.

In der Komponentenschicht 5 sind hier beispielhaft zwei Chips 9 und weitere elektronische Komponenten 9' eingebettet. Unterhalb der Chips 9 befindet sich ein Metallkern 49, auf dem die Chips 9 und weitere elektronische Komponenten 9' mittels eines Klebers 45 aufgebracht sind.

Unterhalb des Metallkerns 49 sind noch weitere eingebettete Komponenten 9' vorhanden. Zusätzlich ist noch ein freier Bereich vorhanden, in dem sich eine Kühlkomponente in Form eines Kühlkörpers 90 befindet. Dieser Kühlkörper 90 ist dabei unterhalb der beiden Chips 9 angeordnet, sodass vor allem die Wärme dieser im Allgemeinen sehr temperaturempfindlichen elektronischen Komponenten abgeführt werden kann. Es wird also ein sog. Heat sink gebildet.

Für die Kontaktierung sind die beiden Chips 9 über Verbindungsstrukturen 8 mit Lotkugeln 47 an der Unterseite der Modulanordnung 1 verbunden.

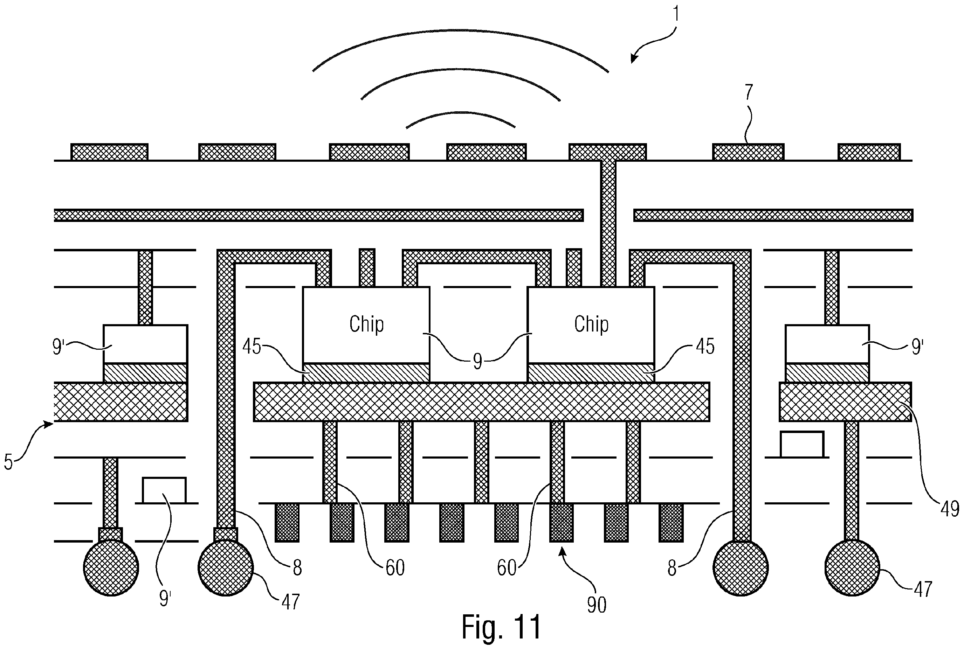

Die Ausgestaltung der Fig. 11 unterscheidet sich von der Ausgestaltung der Fig. 10 darin, dass sich unterhalb des Metallkerns 49 mehrere Schichten befinden, durch die die Verbindungsstrukturen 8 sowie Durchkontaktierungen 60 (sog. thermal vias) hindurchgeführt sind. Damit befindet sich die elektronische Kontaktierung der Modulanordnung 1 sowie die Abführung der thermischen Energie auf der Unterseite der Modulanordnung 1, wobei die Antennenvorrichtung 7 die Oberseite der Modulanordnung 1 bildet. Für die Abführung der Wärme der Chips 9 dient insbesondere der Heat sink 90, der über die Durchkontaktierungen 60 mit dem Metallkern 49 verbunden ist. Die Chips 9 sind über einen Kleber 45 auf dem Metallkern 49 im Bereich des Kühlkörpers 60 befestigt. Die vier beispielhaft dargestellten Lotkugeln 47 haben dabei die gleiche Dimensionierung und befinden sich auf der gleichen Höhe.

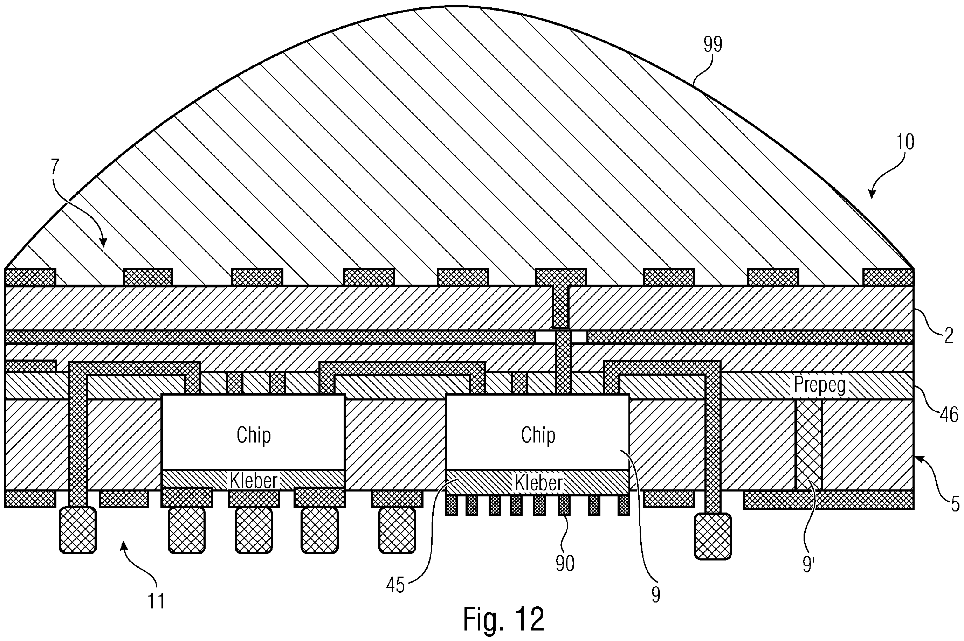

In der Ausgestaltung der Modulanordnung 1 der Fig. 12 befindet sich oberhalb der Antennenvorrichtung 7 und damit auf der Oberseite der Antennenschicht 2 eine Linse als Struktur 99 zur Fokussierung der Strahlung der Antennenvorrichtung 7.

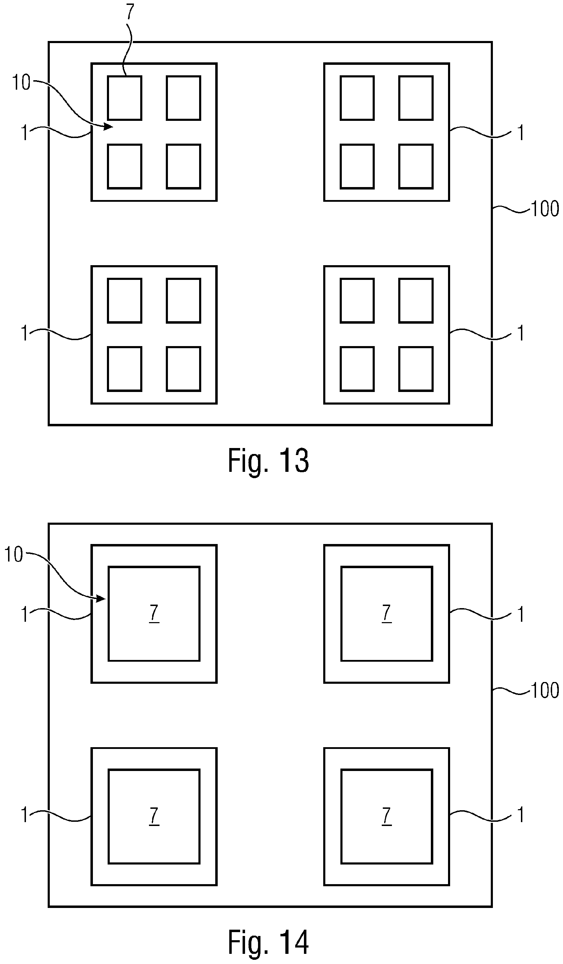

Die Fig. 13 und 14 zeigen jeweils eine Vorrichtung 100 mit mehreren Modulanordnungen 1. Dargestellt sind jeweils vier Modulanordnungen 1 als Beispiel für eine n ^{∗} n Matrix, wobei die Zahl n hier den Wert 2 hat. Die Modulanordnungen 1 werden in einer Ausgestaltung so angesteuert, dass sie gemeinsam elektromagnetische Signale einer gewünschten Form abstrahlen (sog. "Beamforming"). Die beiden Varianten der Vorrichtung 100 unterscheiden sich bezüglich der Modulanordnungen 1 darin, ob die Antennenvorrichtungen 7 auf der Oberseite 10 der Modulanordnungen 1 jeweils eine unterbrochene (Fig. 13) oder eine durchgehende (Fig. 14) Oberfläche aufweisen.

Obwohl manche Aspekte im Zusammenhang mit einer Vorrichtung beschrieben wurden, versteht es sich, dass diese Aspekte auch eine Beschreibung des entsprechenden Herstellungsverfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Modulanordnung (1),
wobei die Modulanordnung (1) mindestens eine Antennenschicht (2), eine Abschirmschicht (3), eine Verteilungsschicht (4) und eine Komponentenschicht (5) aufweist,
wobei die Antennenschicht (2) eine integrierte Antennenvorrichtung (7) trägt, wobei die Abschirmschicht (3) derartig ausgestaltet ist, eine abschirmende Wirkung gegenüber elektromagnetischen Signalen zu haben,
wobei die Verteilungsschicht (4) Strukturen (8) zum Verteilen von Signalen und/oder elektrischer Energie aufweist,
wobei die Komponentenschicht (5) eingebettete elektronische Komponenten (9, 9', 9") trägt, **gekennzeichnet dadurch, dass** in der Antennenschicht (2) Löcher (20) angeordnet sind, und
wobei die Löcher (20) so ausgestaltet und angeordnet sind, dass sich eine photonische Bandlückenstruktur ergibt, um Oberflächenwellen zu filtern.

2. Modulanordnung (1) nach Anspruch 1,
wobei ausgehend von einer Oberseite (10) zu einer Unterseite (11) der Modulanordnung (1) folgende Abfolge gegeben ist: die Antennenschicht (2), die Abschirmschicht (3), die Verteilungsschicht (4) und die Komponentenschicht (5).

3. Modulanordnung (1) nach Anspruch 2,
wobei mindestens ein Metallkern (49) vorhanden ist, und
wobei der Metallkern (49) unterhalb der Komponentenschicht (5) befindlich ist.

4. Modulanordnung (1) nach Anspruch 2 oder 3,
wobei Kontakte (12) zur elektrischen Kontaktierung der Modulanordnung (1) auf der Unterseite (11) befindlich sind.

5. Modulanordnung (1) nach einem der Ansprüche 1 bis 4,
wobei - vorzugsweise oberhalb der Antennenschicht (2) - mindestens eine Struktur (99) zur Fokussierung der Strahlung der Antennenvorrichtung (7) vorhanden ist.

6. Modulanordnung (1) nach einem der Ansprüche 1 bis 5,
wobei mindestens eine Kühlkomponente (6, 90) vorhanden ist.

7. Modulanordnung (1) nach einem der Ansprüche 1 bis 6,
wobei mindestens eine eingebettete elektronische Komponente (9, 9', 9") mit einem Kühlkörper (90) thermisch verbunden ist.

8. Modulanordnung (1) nach einem der Ansprüche 1 bis 6,
wobei mindestens eine eingebettete elektronische Komponente (9, 9', 9") über einen Metallkern (49) mit einem Kühlkörper (90) thermisch verbunden ist.

9. Modulanordnung (1) nach einem der Ansprüche 1 bis 6,
wobei mindestens eine eingebettete elektronische Komponente (9, 9', 9") über mindestens eine Durchkontaktierung (8) mit einem Kühlkörper (90) thermisch verbunden ist.

10. Modulanordnung (1) nach einem der Ansprüche 1 bis 6,
wobei mindestens eine eingebettete elektronische Komponente (9, 9', 9") über einen Metallkern (49) und über mindestens eine Durchkontaktierung (8) mit einem Kühlkörper (90) thermisch verbunden ist.

11. Modulanordnung (1) nach einem der Ansprüche 1 bis 10,
wobei nur die Komponentenschicht (5) elektronische Komponenten (9, 9', 9") trägt.

12. Modulanordnung (1) nach einem der Ansprüche 1 bis 11,
wobei die elektronischen Komponenten (9, 9') in der Komponentenschicht (5) eingebettet sind.

13. Modulanordnung (1) nach einem der Ansprüche 1 bis 12,
wobei die Modulanordnung (1) eine Temperierungsschicht (6) aufweist.

14. Modulanordnung (1) nach Anspruch 13,
wobei die Temperierungsschicht (6) ausgehend von einer Oberseite (10) zu einer Unterseite (11) der Modulanordnung (1) der Komponentenschicht (5) folgt.

15. Modulanordnung (1) nach einem der Ansprüche 1 bis 14,
wobei die Abschirmschicht (3) mindestens zwei Teilschichten (30) aufweist.

16. Modulanordnung (1) nach Anspruch 15,
wobei sich zwischen den zwei Teilschichten (30) eine Aussparung (31) befindet.

17. Modulanordnung (1) nach einem der Ansprüche 1 bis 16,
wobei in der Modulanordnung (1) mindestens eine elektronische Komponente (9, 9', 9") eingebettet ist,
wobei in der Modulanordnung (1) mindestens eine Antennenvorrichtung (7) integriert ist, und
wobei mindestens eine Kühlkomponente (6, 90) zum Abtransport von thermischer Energie vorhanden ist.

18. Modulanordnung (1) nach einem der Ansprüche 1 bis 17,
wobei die Antennenschicht (2) und/oder das Material der Antennenschicht (2) aus einem anderen Material als die anderen Schichten (3, 4, 5, 49) besteht.

19. Vorrichtung (100) mit Modulanordnungen (1),
wobei die Modulanordnungen (1) nach einem der Patentansprüche 1 bis 19 ausgestaltet sind.

20. Vorrichtung (100) nach Anspruch 19,
wobei die Modulanordnungen (1) in einer Matrix angeordnet sind.

21. Verfahren zur Herstellung einer Modulanordnung (1),
wobei eine Antennenschicht (2) mit einer integrierten Antennenvorrichtung (7) erzeugt wird,
wobei eine Abschirmschicht (3) erzeugt wird,
wobei eine Verteilungsschicht (4) erzeugt wird,
wobei eine Komponentenschicht (5) mit eingebetteten Komponenten (9, 9') erzeugt wird,
wobei mindestens die Antennenschicht (2), die Abschirmschicht (3), die Verteilungsschicht (4) und die Komponentenschicht (5) miteinander verbunden und/oder zumindest teilweise gemeinsam miteinander erzeugt werden, **gekennzeichnet dadurch, dass** in der Antennenschicht (2) Löcher (20) angeordnet werden, und
wobei die Löcher (20) so ausgestaltet und angeordnet werden, dass sich eine photonische Bandlückenstruktur ergibt, um Oberflächenwellen zu filtern.

22. Verfahren nach Anspruch 21, wobei wenigstens eine Schicht (2, 3, 4, 5) separat von den anderen Schichten (2, 3, 4, 5) erzeugt wird.

23. Verfahren nach Anspruch 21 oder 22, wobei die Antennenschicht (2) separat von den anderen Schichten (2) erzeugt und mit diesen verbunden wird.

24. Verfahren nach einem der Ansprüche 21 bis 23, wobei mindestens ein Metallkern (49) erzeugt wird.

25. Verfahren nach einem der Ansprüche 21 bis 24, wobei mindestens ein Kühlkörper (90) aufgebracht wird.

26. Verfahren nach einem der Ansprüche 21 bis 25, wobei mindestens eine Struktur (99) zur Fokussierung der Strahlung der Antennenvorrichtung (7) erzeugt wird.

27. Verfahren nach einem der Ansprüche 21 bis 26, wobei das Herstellungsverfahren der Antennenschicht (2) und/oder das Material der Antennenschicht (2) unterschiedlich zum Herstellungsverfahren anderer Schichten (3, 4, 5, 49) bzw. zu Materialien anderer Schichten (3, 4, 5, 49) sind/ist.

## Claims

1. The module arrangement (1),
wherein the module arrangement (1) comprises at least an antenna layer (2), a shielding layer (3), a distribution layer (4) and a component layer (5),
wherein the antenna layer (2) supports an integrated antenna device (7),
wherein the shielding layer (3) is implemented so as to be of a shielding effect relative to electromagnetic signals,
wherein the distribution layer (4) comprises structures (8) for distributing signals and/or electrical energy,
wherein the component layer (5) supports embedded electronic components (9, 9', 9"),
**characterized in that** holes (20) are arranged in the antenna layer (2), and
wherein the holes (20) are implemented and arranged such that the result is a photonic bandgap structure for filtering surface waves.

2. The module arrangement (1) in accordance with claim 1,
wherein, starting from a top side (10) towards a bottom side (11) of the module arrangement (1), the following sequence is provided: antenna layer (2), shielding layer (3), distribution layer (4) and component layer (5).

3. The module arrangement (1) in accordance with claim 2,
wherein at least one metal core (49) is provided, and
wherein the metal core (49) is located below the component layer (5).

4. The module arrangement (1) in accordance with claim 2 or 3,
wherein contacts (12) for electrically contacting the module arrangement (1) are located on the bottom side (11).

5. The module arrangement (1) in accordance with any of claims 1 to 4,
wherein at least one structure (99) for focusing the radiation of the antenna device (7) is provided - preferably above the antenna layer (2).

6. The module arrangement (1) in accordance with any of claims 1 to 5,
wherein at least one cooling component (6, 90) is provided.

7. The module arrangement (1) in accordance with any of claims 1 to 6,
wherein at least one embedded electronic component (9, 9', 9") is thermally connected to a cooling body (90).

8. The module arrangement (1) in accordance with any of claims 1 to 6,
wherein at least one embedded electronic component (9, 9', 9") is thermally connected to a cooling body (90) via a metal core (49).

9. The module arrangement (1) in accordance with any of claims 1 to 6,
wherein at least one embedded electronic component (9, 9', 9") is thermally connected to a cooling body (90) via at least one via hole (8).

10. The module arrangement (1) in accordance with any of claims 1 to 6,
wherein at least one embedded electronic component (9, 9', 9") is thermally connected to a cooling body (90) via a metal core (49) and via at least one via hole (8).

11. The module arrangement (1) in accordance with any of claims 1 to 10,
wherein only the component layer (5) supports electronic components (9, 9', 9").

12. The module arrangement (1) in accordance with any of claims 1 to 11,
wherein the electronic components (9, 9') are embedded in the component layer (5).

13. The module arrangement (1) in accordance with any of claims 1 to 12,
wherein the module arrangement (1) comprises a temperature control layer (6).

14. The module arrangement (1) in accordance with claim 13,
wherein the temperature control layer (6), starting from a top side (10) towards a bottom side (11) of the module arrangement (1), follows after the component layer (5).

15. The module arrangement (1) in accordance with any of claims 1 to 14,
wherein the shielding layer (3) comprises at least two sublayers (30).

16. The module arrangement (1) in accordance with claim 15,
wherein a recess (31) is located between the two sublayers (30).

17. The module arrangement (1) in accordance with any of claims 1 to 16,
wherein at least one electronic component (9, 9', 9") is embedded in the module arrangement (1),
wherein at least one antenna device (7) is integrated in the module arrangement (1), and
wherein at least one cooling component (6, 90) for removing thermal energy is provided.

18. The module arrangement (1) in accordance with any of claims 1 to 17,
wherein the antenna layer (2) and/or the material of the antenna layer (2) consist of a different material than the other layers (3, 4, 5, 49).

19. The device (100) comprising module arrangements (1),
wherein the module arrangements (1) are implemented in accordance with any of claims 1 to 19.

20. The device (100) in accordance with claim 19,
wherein the module arrangements (1) are arranged to form a matrix.

21. A method for manufacturing a module arrangement (1),
wherein an antenna layer (2) comprising an integrated antenna device (7) is produced,
wherein a shielding layer (3) is produced,
wherein a distribution layer (4) is produced,
wherein a component layer (5) comprising embedded components (9, 9') is produced,
wherein at least the antenna layer (2), the shielding layer (3), the distribution layer (4) and the component layer (5) are connected to one another and/or are at least partly produced together,
**characterized in that** holes (20) are arranged in the antenna layer (2), and wherein the holes (20) are implemented and arranged such that the result is a photonic bandgap structure for filtering surface waves

22. The method in accordance with claim 21,
wherein at least one layer (2, 3, 4, 5) is produced separately from the other layers (2, 3, 4, 5).

23. The method in accordance with claim 21 or 22,
wherein the antenna layer (2) is produced separately from the other layers (2) and connected to these.

24. The method in accordance with any of claims 21 to 23,
wherein at least one metal core (49) is produced.

25. The method in accordance with any of claims 21 to 24,
wherein at least one cooling body (90) is applied.

26. The method in accordance with any of claims 21 to 25,
wherein at least one structure (99) for focusing the radiation of the antenna device (7) is produced.

27. The method in accordance with any of claims 21 to 26,
wherein the manufacturing method of the antenna layer (2) and/or the material of the antenna layer (2) is/are different from the manufacturing method of other layers (3, 4, 5, 49) and materials of other layers (3, 4, 5, 49), respectively.

## Revendications

1. Aménagement de module (1),
dans lequel l'aménagement de module (1) présente au moins une couche d'antenne (2), une couche de blindage (3), une couche de distribution (4) et une couche de composants (5),
dans lequel la couche d'antenne (2) porte un dispositif d'antenne intégré (7),
dans lequel la couche de blindage (3) est conçue de manière à avoir un effet de blindage contre les signaux électromagnétiques,
dans lequel la couche de distribution (4) présente des structures (8) destinées à distribuer des signaux et/ou de l'énergie électrique, dans lequel la couche de composants (5) porte des composants électroniques incorporés (9, 9', 9"),
**caractérisé par le fait que**
dans la couche d'antenne (2) sont disposés des trous (20), et
dans lequel les trous (20) sont conçus et disposés de sorte qu'ils résultent en une structure à bande interdite photonique pour filtrer les ondes de surface.

2. Aménagement de module (1) selon la revendication 1,
dans lequel, partant d'un côté supérieur (10) vers un côté inférieur (11) de l'aménagement de module (1), est respectée la séquence suivante: la couche d'antenne (2), la couche de blindage (3), la couche de distribution (4) et la couche de composants (5).

3. Aménagement de module (1) selon la revendication 2,
dans lequel est présent au moins un noyau métallique (49), et
dans lequel le noyau métallique (49) se situe au-dessous de la couche de composants (5).

4. Aménagement de module (1) selon la revendication 2 ou 3,
dans lequel des contacts (12) pour établir un contact électrique avec l'aménagement de module (1) se situent sur la face inférieure (11).

5. Aménagement de module (1) selon l'une des revendications 1 à 4,
dans lequel - de préférence au-dessus de la couche d'antenne (2) - est présente au moins une structure (99) permettant de focaliser le rayonnement du dispositif d'antenne (7).

6. Aménagement de module (1) selon l'une des revendications 1 à 5,
dans lequel est présent au moins un composant de refroidissement (6, 90).

7. Aménagement de module (1) selon l'une des revendications 1 à 6,
dans lequel au moins un composant électronique incorporé (9, 9', 9") est connecté thermiquement à un dissipateur thermique (90).

8. Aménagement de module (1) selon l'une des revendications 1 à 6,
dans lequel au moins un composant électronique incorporé (9, 9', 9") est connecté thermiquement à un dissipateur thermique (90) par l'intermédiaire d'un noyau métallique (49).

9. Aménagement de module (1) selon l'une des revendications 1 à 6,
dans lequel au moins un composant électronique incorporé (9, 9', 9") est connecté thermiquement à un dissipateur thermique (90) par l'intermédiaire d'au moins un via (8).

10. Aménagement de module (1) selon l'une des revendications 1 à 6,
dans lequel au moins un composant électronique incorporé (9, 9', 9") est connecté thermiquement à un dissipateur thermique (90) par l'intermédiaire d'un noyau métallique (49) et par l'intermédiaire d'au moins un via (8).

11. Aménagement de module (1) selon l'une des revendications 1 à 10,
dans lequel seule la couche de composants (5) porte des composants électroniques (9, 9', 9").

12. Aménagement de module (1) selon l'une des revendications 1 à 11,
dans lequel les composants électroniques (9, 9') sont incorporés dans la couche de composants (5).

13. Aménagement de module (1) selon l'une des revendications 1 à 12,
dans lequel l'aménagement de module (1) présente une couche de régulation de température (6).

14. Aménagement de module (1) selon la revendication 13,
dans lequel la couche de régulation de température (6) suit, partant d'un côté supérieur (10) vers un côté inférieur (11) de l'aménagement de module (1), la couche de composants (5).

15. Aménagement de module (1) selon l'une des revendications 1 à 14,
dans lequel la couche de blindage (3) présente au moins deux couches partielles (30).

16. Aménagement de module (1) selon la revendication 15,
dans lequel entre les deux couches partielles (30) se trouve un évidement (31).

17. Aménagement de module (1) selon l'une des revendications 1 à 16,
dans lequel au moins un composant électronique (9, 9', 9") est incorporé dans l'aménagement de module (1),
dans lequel au moins un dispositif d'antenne (7) est incorporé dans l'aménagement de module (1), et
dans lequel est présent au moins un composant de refroidissement (6, 90) destiné à l'évacuation de l'énergie thermique.

18. Aménagement de module (1) selon l'une des revendications 1 à 17,
dans lequel la couche d'antenne (2) et/ou le matériau de la couche d'antenne (2) est constitué d'un matériau différent de celui des autres couches (3, 4, 5, 49).

19. Dispositif (100) avec des aménagements de module (1),
dans lequel les aménagements de module (1) sont conçus selon l'une des revendications 1 à 19.

20. Dispositif (100) selon la revendication 19,
dans lequel les aménagements de module (1) sont disposés dans une matrice.

21. Procédé de fabrication d'un aménagement de module (1),
dans lequel est générée une couche d'antenne (2) avec un dispositif d'antenne intégré (7),
dans lequel est générée une couche de blindage (3),
dans lequel est générée une couche de distribution (4),
dans lequel est générée une couche de composants (5) avec des composants incorporés (9, 9'),
dans lequel au moins la couche d'antenne (2), la couche de blindage (3), la couche de distribution (4) et la couche de composants (5) sont connectées l'une à l'autre et/ou au moins générées partiellement ensemble,
**caractérisé par le fait que**
dans la couche d'antenne (2) sont disposés des trous (20), et
dans lequel les trous (20) sont conçus et disposés de sorte qu'ils résultent en une structure à bande interdite photonique pour filtrer les ondes de surface.

22. Procédé selon la revendication 21, dans lequel au moins une couche (2, 3, 4, 5) est générée séparément des autres couches (2, 3, 4, 5).

23. Procédé selon la revendication 21 ou 22, dans lequel la couche d'antenne (2) est générée séparément des autres couches (2) et assemblée avec ces dernières.

24. Procédé selon l'une des revendications 21 à 23, dans lequel est généré au moins un noyau métallique (49).

25. Procédé selon l'une des revendications 21 à 24, dans lequel est placé au moins un dissipateur thermique (90).

26. Procédé selon l'une des revendications 21 à 25, dans lequel est générée au moins une structure (99) permettant de focaliser le rayonnement du dispositif d'antenne (7).

27. Procédé selon l'une des revendications 21 à 26, dans lequel le procédé de fabrication de la couche d'antenne (2) et/ou le matériau de la couche d'antenne (2) sont/est différents du procédé de fabrication d'autres couches (3, 4, 5, 49) ou des matériaux d'autres couches (3, 4, 5, 49).
